# EUROPÄISCHE PATENTANMELDUNG

(11) **EP 1 669 763 A1**
(43) Veröffentlichungstag der Anmeldung: **14.06.2006**
(21) Anmeldenummer: 05017836.7
(22) Anmeldetag: 17.08.2005
(51) Int. Cl.: G01R 11/24, H02B 1/46

(54) **Elektronischer Elektrizitätszähler**

(30) Priorität: 10.12.2004 DE 202004019104 U
(71) Anmelder: EMH Elektrizitätszähler GmbH & Co KG, 19243 Wittenburg (DE)
(72) Erfinder: Malek, Norbert, 21438 Thieshope (DE)
(74) Vertreter: Hauck, Graalfs, Wehnert, Döring, Siemons

(57) **Zusammenfassung**

Elektronischer Elektrizitätszähler (10), mit einem Gehäuse (14), das alle Komponenten und Bauteile eines elektronischen Elektrizitätszählers enthält, einschließlich eines Displays und Stromsensoren, und das lösbar mit einer Zählerplattform (12) verbindbar ist, wobei die Zählerplattform Anschlußmittel für die Phasen der Versorgungsleitungen enthält und ein plombierbares Plombierelement (26), das sich durch das Gehäuse hindurch erstreckt, in einer ersten Position das Gehäuse an der Plattform verriegelt und in einer zweiten Position entriegelt, wobei im Gehäuse dem Plombierelement ein Positionssensor (34) zugeordnet ist, der detektiert, wenn das Plombierelement sich bewegt oder von der Verriegelungs- in die Entriegelungsstellung verstellt wird und ein Signal des Positionssensors auf ein Register und/oder ein Display gegeben wird.

## Beschreibung

Die Erfindung bezieht sich auf einen elektronischen Elektrizitätszähler nach dem Oberbegriff des Anspruchs 1.

Es ist bekannt, Elektrizitätszähler zweiteilig auszubilden in der Weise, daß eine Zählerplattform mit den Anschlußmöglichkeiten für die Versorgungsleitungen versehen ist ständig am Anbringungsort verbleibt, während ein Gehäuse, das alle Bauteile und Komponenten eines elektronischen Elektrizitätszählers enthält, lösbar mit der Plattform verbindbar ist. Die Verbindung geschieht z.B. mit Hilfe von hakenartigen Vorsprüngen des Gehäuses, welche in entsprechende Ausnehmungen der Plattform eingreifen. Es findet dabei eine Verhakung zwischen den Teilen statt. Ein Plombierelement, das sich durch das Gehäuse bis zur Plattform hin erstreckt, verriegelt das Gehäuse an der Zählerplattform. Diese Verriegelung kann nur aufgehoben werden, wenn das Plombierelement die Verriegelung löst. Das Plombierelement ist seinerseits durch eine Plombe gesichert und kann nur betätigt werden, wenn die Plombe beschädigt oder entfernt wird.

Die beschriebene Anordnung hat den Vorteil, daß bei einem Lösen des Zählers bzw. des Gehäuses für den Zähler von der Zählerplattform die Verbindung zum Versorger nicht unterbrochen ist und keine gefährlichen Arbeiten unter Spannung durchgeführt werden müssen. Ein Zähleraustausch läßt sich innerhalb kürzester Zeit bewerkstelligen, so daß für den Energieversorger Verluste nicht entstehen. Die Zählerplattform ist entweder an der Wand eines Zählerschrankes angebracht oder Teil der Wand eines Zählerschrankes.

Der Erfindung liegt die Aufgabe zugrunde, eine elektronischen Elektrizitätszähler der eingangs genannten Art so auszubilden, daß Manipulationen erkannt werden.

Diese Aufgabe wird durch die Merkmale des Anspruchs 1 gelöst.

Wie eingangs erwähnt, bleiben die Versorgungsleitungen angeschlossen, wenn der Elektrizitätszähler von der Zählerplattform entfernt wird. Dadurch können sich Verbraucher veranlaßt sehen, durch Abnahme des Gehäuses und Überbrückung von Kontakten Strom zu erschleichen. Bei der erfindungsgemäßen Lösung kann zwar nicht verhindert werden, daß ein Stromverbraucher den Elektrizitätszähler manipuliert, die Erfindung ermöglicht jedoch, eine solche Manipulation erkennbar zu machen.

Bei der Erfindung wird das Plombierelement, z.B. ein Plombierstift, der durch das Gehäuse des Elektrizitätszählers hindurchgeführt und mit der Zählerplattform verriegelt werden kann, mit einem Positionssensor überwacht. Der Positionssensor ermittelt, ob das Plombierelement bewegt oder von einer Verriegelungsstellung in eine Entriegelungsstellung verstellt worden ist. Das Signal des Positionssensors kann in einem Ereignisregister registriert und/oder auf dem Display, das einem derartigen Elektrizitätszähler zugeordnet ist, angezeigt werden. Das Plombierelement, beispielsweise ein Plombierstift, wird z.B. drehend betätigt und bewegt sich dabei zugleich axial. Diese Bewegung des Plombierstiftes kann von einem geeigneten Sensor erfaßt werden. Der Sensor kann z.B. elektrisch arbeiten, indem ein elektromechanischer Schalter betätigt wird. In einer anderen Ausgestaltung der Erfindung kann die Ruheposition des Plombierstiftes von einem magnetisch wirkend Element, z.B. einem Hall-Element, oder einem optischen Sensor erfaßt werden.

Die elektronischen Bauteile und Komponenten eines elektronischen Elektrizitätszählers sind üblicherweise auf einer Leiterplatte angebracht, die innerhalb des Gehäuses angeordnet ist. Nach einer Ausgestaltung der Erfindung erstreckt sich das Plombierelement durch eine Öffnung oder eine Ausnehmung der Leiterplatte, und der Positionssensor ist auf der Leiterplatte nahe der Öffnung oder Ausnehmung angeordnet.

Elektrizitätszähler weisen einen sogenannten Betriebsstundenzähler auf oder auch eine Echtzeituhr. Erfindungsgemäß kann ein Signal des Positionssensors mit dem Betriebsstundenzähler bzw. dem Zeitsignal verknüpft werden, um festzustellen, zu welchem Zeitpunkt oder zu welcher Betriebsstunde es erzeugt worden ist. Damit ist zugleich eine zeitliche Zuordnung der Manipulation ermöglicht.

Es versteht sich, daß dem erfindungsgemäßen Elektrizitätszähler ein Mittel zugeordnet ist, um die vom Sensor indizierte Warnmeldung zurückzusetzen.

Um zu verhindern, daß bei der Installation des erfindungsgemäßen Elektrizitätszählers die Manipulationserkennung ausgelöst wird, kann nach einer Ausgestaltung der Erfindung vorgesehen werden, daß das Signal des Positionssensors erst in das Register eingespeichert wird, wenn das Positionselement seine erste Verriegelungsposition erreicht hat oder wenn nach Erreichen einer ersten Verriegelungsposition eine vorgegebene Zeit verstrichen ist. So erkennt der Positionssensor, wenn der Plombierstift bei der Installation des Zählers in die Verriegelungsposition gebracht ist. Zu diesem Zeitpunkt kann ein Zeitverzögerungsglied gestartet werden, das verhindert, daß eine Manipulationsmeldung erzeugt wird, solange die voreingestellte Zeit nicht abgelaufen ist. Alternativ kann der erfindungsgemäße Elektrizitätszähler "scharf" gestellt werden, wenn bei der Installation der Plombierstift das erste Mal seine Verriegelungsposition einnimmt. Als weitere Bedingung ist hinzuzunehmen, daß der Zähler hierbei an Spannung liegen muß.

Nach einer weiteren Ausgestaltung der Erfindung kann ein weiterer Sensor dem Elektrizitätszähler zugeordnet werden, der feststellt, wenn ein Spannungsabfall stattgefunden hat. Dieser wird ebenfalls in das Ereignisregister eingespeichert. Hierdurch wird die Information erhalten, daß ein Totalausfall der Meß-/Versorgungsspannung des Zählers stattgefunden hat. Auch dieses Ereignis kann mit der Zeitinformation verknüpft und festgehalten werden.

Die Erfindung wird nachfolgend anhand eines in Zeichnungen dargestellten Ausführungsbeispiels näher erläutert.
- Fig. 1: zeigt äußerst schematisch einen Elektrizitätszähler in Draufsicht.
- Fig. 2: zeigt einen Schnitt durch den Elektrizitätszähler nach Fig. 1 entlang der Linie 2-2.
- Fig. 3: zeigt ein Blockschaltbild eines Teils der Elektronik des Elektrizitätszählers nach den Fign. 1 und 2.
- Fig. 4: zeigt ein weiteres Blockschaltbild für die Datenausgabe des Elektrizitätszählers nach den Fign. 1 bis 3.

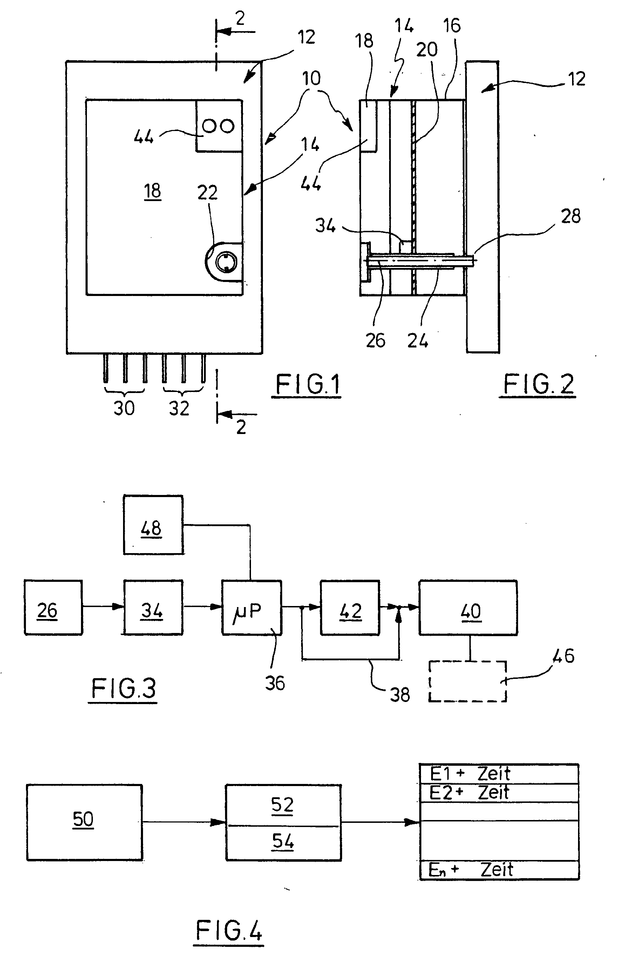

In den Fign. 1 und 2 ist ein elektronischer Elektrizitätszähler 10 schematisch dargestellt. Er ist an einer Zählerplattform 12 angebracht, die innerhalb eines Zählerschrankes an einer Wand angebracht ist. Alternativ kann die Zählerplattform auch die Wand eines Zählerschrankes bilden.

Auf die Zählerplattform 12 ist ein quaderförmiges Gehäuse 14 aufgesetzt. Das Zählergehäuse 14 besteht aus einem kastenförmigen Unterteil 16, das mit der Zählerplattform 12 verbunden wird, und einem Deckel 18, der unlösbar mit dem Unterteil 16 verbindbar ist. Die Verbindung zwischen Zählerplattform 12 und Unterteil 16 ist nicht dargestellt. Zum Beispiel greifen hakenförmige Ansätze am Boden des Unterteils 16 in entsprechende Schlitze der Zählerplattform 12.

Im Gehäuse 14 sind alle für einen elektronischen Elektrizitätszähler notwendigen Bauteile und Komponenten untergebracht. Der Aufbau dieser Teile ist nicht dargestellt. Man erkennt lediglich eine Leiterplatte 20, welche die Komponenten und Bauteile des Elektrizitätszählers trägt und in geeigneter Weise im Unterteil 16 befestigt ist.

Wie aus Fig. 1 zu erkennen, weist der Deckel 18 einen eingesenkten Bereich 22 auf, an den, wie in Fig. 2 zu erkennen, eine zylindrische Hülse 24 angeformt ist, die sich durch eine Öffnung der Leiterplatte 20 hindurch bis nahe an den Boden des Unterteils 16 erstreckt. Durch die Hülse 24 ist ein Plombierstift 26 hindurchgeführt, der durch eine Öffnung im Boden des Unterteils 16 hindurcherstreckt ist und in eine Verriegelungsöffnung der Zählerplattform 12 hinein. Dadurch ist das Gehäuse 14 gehindert, gegenüber der Zählerplattform verschoben zu werden. Der Plombierstift 26 kann mit einem Gewindeabschnitt versehen werden, welcher mit einem Gewindeabschnitt in der Öffnung im Boden des Unterteils 16 zusammenwirkt. Der Plombierstift 26 steht geringfügig über eine Öffnung in der Einsenkung 22 des Deckels 18 vor. Die Einsenkung 22 dient als Tasche für eine Plombe. Mit Hilfe des Plombierstiftes 26 wird das Gehäuse 14 an der Zählerplattform 12 verriegelt, und eine Entriegelung ist nur möglich, wenn die Plombe entfernt oder zerstört wird. In Fig. 1 ist bei 30 bzw. 32 der Anschluß des Netzes bzw. des Verbrauchers angedeutet. In der Zählerplattform 12 sind entsprechende Kontakte angeordnet, die mit Leiterabschnitten im Gehäuse 14 zusammenwirken, damit der zum Verbraucher fließende Strom und die Spannung gemessen werden können.

Auf der Leiterplatte 12 ist nahe der Öffnung für die Hülse 24 ein Positionssensor 34 angeordnet. Er stellt fest, wenn der Plombierstift 26 bewegt worden ist.

In Fig. 3 ist die Wirkungsweise des Sensors 34 angedeutet. Fig. 3 ist ein Wirtschaftsplan, der vorzugsweise durch eine Software verwirklicht ist. Eine Bewegung des Plombierstiftes 26, etwa aus einer Verriegelungs- in eine Entriegelungsposition, führt zu einer Ansprache des Positionssensors 34, der ein entsprechendes Signal auf einen Mikroprozessor 36 gibt, der zur elektronischen Schaltungsanordnung des nicht weiter dargestellten und beschriebenen elektronischen Elektrizitätszählers gehört. Ein entsprechendes Ausgangssignal (Ereignissignal) wird über 38 auf ein Register 40 geleitet. Das Ausgangssignal des Mikroprozessors 36 dient zugleich dazu, einen Zeitgeber oder Betriebsstundenzähler 42 zu veranlassen, ein entsprechendes Zeit- oder Betriebsstundensignal auf das Register 40 zu geben. Dadurch ist im Register 40 die Tatsache gespeichert, daß zu einem angegebenen Zeitpunkt der Plombierstift 26 bewegt wurde. Das Register 40 ist so geschaltet, daß es über eine übliche Datenausgabe abgefragt werden kann. Eine solche Datenausgabe ist bei 44 in den Fign. 1 und 2 dargestellt. Sie geschieht z.B. auf optischem Wege. Zusätzlich oder alternativ kann die Tatsache der Verstellung des Plombierstiftes 26 über eine gestrichelt gezeigte Anzeige 46 wiedergegeben werden, z.B. über ein übliches Display, über welches derartige Elektrizitätszähler verfügen.

In Fig. 3 ist ferner ein Block 48 vorgesehen, der die Spannungsmeßvorrichtung (nicht gezeigt), die überlicherweise zu einem Elektrizitätszähler gehört, wiedergibt, wodurch bei Wegfall der Spannung ebenfalls ein Signal auf den Mikroprozessor 36 gegeben wird. Mithin kann das Ereignis des Erkennens einer Manipulation am Plombierstift 26 auch mit einem Spannungsausfall verknüpft werden.

In Fig. 4 ist die Verbindung einer Schnittstelle 50, welche bei 44 in den Fign. 1 und 2 dargestellt ist, mit Zählerdaten 52 und Informationsdaten 54 verknüpft.

Erstes Ereignis E1 hat zu einem ersten Zeitpunkt stattgefunden. Ein zweites Ereignis E2 findet zu einem zweiten Zeitpunkt statt und so fort.

Neben den normalen Zählerdaten, wie sie üblicherweise ausgegeben werden, werden mithin Informationsdaten des Ereignisregisters 40 ausgegeben mit den zugehörigen Zeitinformationen.

## Patentansprüche

1. Elektronischer Elektrizitätszähler, mit einem Gehäuse, das alle Komponenten und Bauteile eines elektronischen Elektrizitätszählers enthält, einschließlich eines Displays und Stromsensoren, und das lösbar mit einer Zählerplattform verbindbar ist, wobei die Zählerplattform Anschlußmittel für die Phasen der Versorgungsleitungen enthält und einem plombierbaren Plombierelement, das sich durch das Gehäuse hindurch erstreckt, in einer ersten Position das Gehäuse an der Plattform verriegelt und in einer zweiten Position entriegelt, **dadurch gekennzeichnet, daß** im Gehäuse (14) dem Plombierelement (26) ein Positionssensor (34) zugeordnet ist, der detektiert, wenn das Plombierelement (26) sich bewegt oder von der Verriegelungs- in die Entriegelungsstellung verstellt wird und ein Signal des Positionssensors (34) auf ein Register (40) und/oder ein Display (46) gegeben wird.

2. Elektrizitätszähler nach Anspruch 1, **dadurch gekennzeichnet, daß** das Plombierelement (26) ein Plombierstift ist, der sich durch das Gehäuse (14) hindurch bis zur Zählerplattform (12) erstreckt.

3. Elektrizitätszähler nach Anspruch 1 oder 2, **dadurch gekennzeichnet, daß** das Plombierelement (26) einen elektrischen Schalter als Positionssensor betätigt.

4. Elektrizitätszähler nach Anspruch 1 oder 2, **dadurch gekennzeichnet, daß** ein optischer Positionssensor vorgesehen ist.

5. Elektrizitätszähler nach Anspruch 1 oder 2, **dadurch gekennzeichnet, daß** ein magnetisch wirkendes Element als Positionssensor vorgesehen ist.

6. Elektrizitätszähler nach einem der Ansprüche 1 bis 5, **dadurch gekennzeichnet, daß** das Plombierelement (26) sich durch eine Öffnung oder Ausnehmung einer Leiterplatte (20) für die elektronischen Komponenten und Bauteile erstreckt und der Positionssensor (26) auf der Leiterplatte (20) nahe der Öffnung oder Ausnehmung angeordnet ist.

7. Elektrizitätszähler nach einem der Ansprüche 1 bis 6, **dadurch gekennzeichnet, daß** er einen Betriebsstunden- bzw. Zeitzähler aufweist und im Register (40) die Betriebsstunden bzw. Zeit gespeichert werden, zu denen der Positionssensor (26) ein Signal erzeugt.

8. Elektrizitätszähler nach einem der Ansprüche 1 bis 7, **dadurch gekennzeichnet, daß** er einen zweiten Sensor aufweist, der feststellt, wenn ein Spannungsabfall der Meßspannung auftritt und das Signal des weiteren Sensors auf das Register (40) gegeben wird.

9. Elektrizitätszähler nach einem der Ansprüche 1 bis 8, **dadurch gekennzeichnet, daß** das Signal des Positionssensors (34) erst in das Register (40) eingespeist wird, wenn das Plombierelement (26) seine erste Verriegelungsposition erreicht hat oder wenn nach Erreichen einer ersten Verriegelungsposition eine vorgegebene Zeit verstrichen ist.
